# FASCICULE DE BREVET EUROPEEN

(11) **EP 4 492 160 B1**
(45) Date de publication et mention de la délivrance du brevet: **08.04.2026**
(21) Numéro de dépôt: 24216887.0
(22) Date de dépôt: 19.03.2019
(51) Int. Cl.: G04B 17/06, G04B 17/22, G04D 3/00

(54) **ORGANE DE SUPPORT POUR LE TRAITEMENT THERMIQUE D'UNE PLAQUETTE**
TRÄGERORGAN ZUR WÄRMEBEHANDLUNG EINES WAFERS
SUPPORT MEMBER FOR THE THERMAL TREATMENT OF A WAFER

(30) Priorité: 20.03.2018 EP 18162729
(43) Date de publication de la demande: 15.01.2025
(62) Demande divisionnaire de: 21182494.1
(73) Titulaire: PATEK PHILIPPE SA GENEVE, 1204 Genève (CH)
(72) Inventeur: JEANNERET, SYLVAIN, 1228 Plan-les-Ouates (CH)
(74) Mandataire: Micheli & Cie SA

(56) Documents cités:
- EP-A1- 3 181 938
- WO-A1-2016/128694

## Description

La présente invention se rapporte à un procédé de fabrication de composants horlogers, tel que divulgué dans les revendications 1 et 2 annexées.

Des procédés de fabrication de composants horlogers en silicium ont été décrits notamment dans les documents EP 0732635, EP 1422436, EP 2215531 et EP 3181938. ainsi que dans le document WO2016/128694A1.

D'autres caractéristiques et avantages de la présente invention apparaîtront à la lecture de la description détaillée suivante faite en référence aux dessins annexés dans lesquels :
- les figures 1 à 11 montrent schématiquement des étapes successives d'un procédé de fabrication de composants horlogers en silicium ;
- les figures 12 et 13 sont respectivement une vue en perspective et une vue de profil d'un organe de support selon l'invention utilisé dans ledit procédé de fabrication de composants horlogers en silicium pour supporter une plaquette de silicium pendant un traitement d'oxydation thermique de cette dernière ;
- les figures 14 et 15 montrent schématiquement une étape dudit procédé de fabrication de composants horlogers en silicium, dans laquelle une plaquette de silicium gravée est libérée d'un substrat composite ;
- la figure 16 montre un substrat composite à partir duquel peut être mis en œuvre un procédé selon un autre exemple de réalisation.

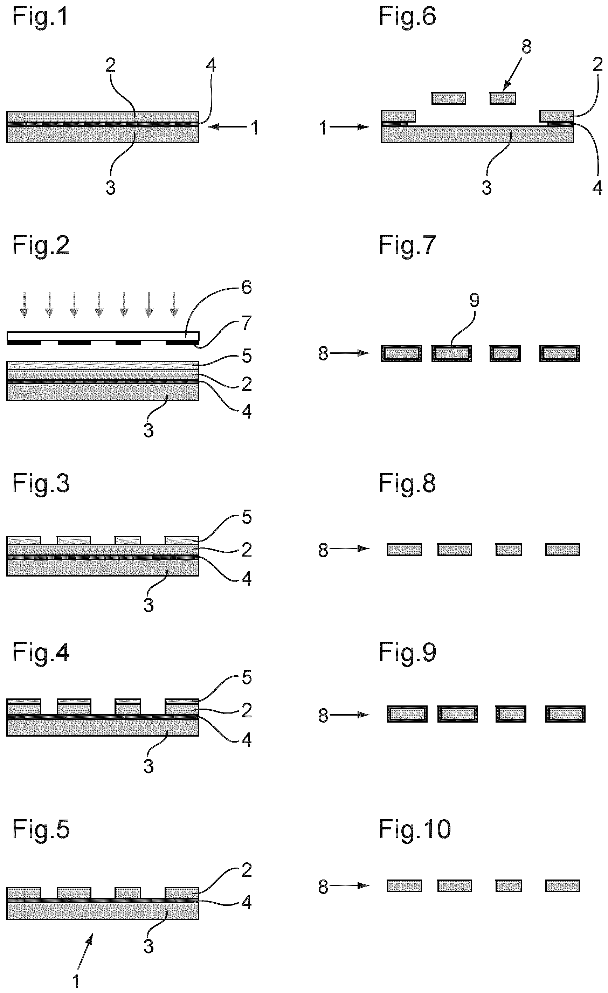

Un procédé de fabrication de composants horlogers en silicium, notamment pour montres-bracelets, comprend selon un exemple de réalisation particulier les étapes successives illustrées aux figures 1 à 11.

A une première étape (figure 1), on se munit d'un substrat 1 de type silicium sur isolant connu sous l'acronyme SOI (Silicon-On-Insulator). Le substrat 1 comprend une couche supérieure de silicium 2, une couche inférieure de silicium 3 et, entre les deux, une couche intermédiaire d'oxyde de silicium 4. Le silicium est monocristallin, polycristallin ou amorphe. Il peut être dopé ou non. L'épaisseur de la couche supérieure de silicium 2 est choisie en fonction de l'épaisseur des composants que l'on souhaite réaliser. La couche inférieure de silicium 3 sert à conférer au substrat 1 une rigidité suffisante facilitant sa manipulation et la mise en œuvre des opérations qui vont être décrites ci-dessous.

A une deuxième étape (figure 2), on dépose sur la couche supérieure de silicium 2 une couche de laque photosensible 5 et on structure cette couche 5 par photolithographie. Plus précisément, on expose la couche de laque photosensible 5 à des rayons ultra-violets à travers un masque 6, typiquement en verre ou en quartz, portant une structure 7, typiquement en chrome, à transférer. Puis la couche de laque photosensible 5 est développée et cuite (figure 3). A l'issue de ces opérations, la couche de laque photosensible 5 présente la même forme que la structure 7 et constitue à son tour un masque, ladite forme correspondant à celle d'un lot de composants horlogers à fabriquer.

A une étape suivante (figure 4), on grave la couche supérieure de silicium 2 à travers le masque de laque photosensible 5 par gravure ionique réactive profonde dite **DRIE** (Deep Reactive Ion Etching) afin de former dans cette couche 2 les composants horlogers. La gravure est arrêtée par la couche intermédiaire d'oxyde de silicium 4, permettant ainsi de définir une épaisseur précise pour les composants horlogers. Les paramètres de gravure peuvent être ajustés en fonction des composants, pour obtenir des caractéristiques particulières en termes par exemple de rugosité ou d'angle des flancs. Les composants horlogers formés dans la couche supérieure de silicium 2 sont de préférence identiques mais ils pourraient en variante être répartis en plusieurs groupes, chaque groupe correspondant à un type de composant. Les composants horlogers comprennent par exemple au moins l'un des types de composants suivants : spiraux, ancres, roues, notamment roues d'échappement, aiguilles, bascules, leviers, ressorts, balanciers, ou des parties de tels composants. Ce procédé convient particulièrement à des composants d'organe réglant et plus généralement à des composants de mouvement horloger nécessitant une faible masse et/ou une faible inertie.

Le masque de laque photosensible 5 est ensuite éliminé par gravure chimique ou gravure plasma (figure 5).

A une étape suivante (figure 6), on libère du substrat 1, d'une manière qui sera décrite plus loin, une plaquette 8 formée par au moins tout ou partie de la couche supérieure de silicium 2 gravée. Cette plaquette 8 contient une structure de base et les composants horlogers attachés à la structure de base par des ponts de matière laissés lors de la gravure.

Puis la plaquette 8 est placée dans un four d'oxydation pour être soumise à un traitement thermique, typiquement entre 600°C et 1300°C, oxydant toute la surface extérieure des composants horlogers (figure 7). La couche d'oxyde de silicium (SiO₂) 9 qui recouvre alors la plaquette 8 et en particulier les composants horlogers se forme en consommant du silicium de la plaquette 8, ce qui fait reculer l'interface entre le silicium et l'oxyde de silicium et atténue les défauts de surface du silicium. En éliminant ensuite l'oxyde de silicium (figure 8), par gravure humide, gravure en phase vapeur ou gravure sèche, on obtient des composants horlogers ayant un bon état de surface. En particulier, la rugosité des flancs due à la gravure DRIE et les défauts cristallins de surface sont fortement réduits.

A ce stade du procédé, on peut mesurer des caractéristiques physiques des composants horlogers ou de certains d'entre eux, notamment leurs dimensions. Grâce à l'étape précédente d'oxydation-désoxydation, ces caractéristiques physiques sont bien définies et leur mesure peut donc être précise, n'étant pas perturbée par les défauts de surface. Dans le cas de spiraux, on peut déterminer leur raideur. Pour un spiral donné, la raideur peut être déterminée en couplant le spiral, alors qu'il est encore attaché à la plaquette 8 ou détaché de la plaquette 8, à un balancier d'inertie prédéterminée, en mesurant la fréquence de l'ensemble balancier-spiral et en déduisant de cette mesure, par calcul, la raideur du spiral. On peut plus particulièrement mettre en œuvre le procédé décrit dans la demande de brevet EP 3181938, à savoir déterminer la raideur des spiraux, calculer une épaisseur de matériau à retirer des spiraux pour obtenir une raideur souhaitée, puis retirer cette épaisseur de matériau afin d'obtenir des spiraux de la raideur souhaitée. Pour retirer ladite épaisseur de matériau, on peut oxyder thermiquement la plaquette 8 et ses composants horlogers (figure 9) puis la désoxyder (figure 10), de la même manière que décrit précédemment en référence aux figures 7 et 8. Les opérations de détermination de la raideur, de calcul de l'épaisseur à retirer et de retrait de cette épaisseur par oxydation-désoxydation peuvent être répétées si nécessaire pour affiner la précision dimensionnelle des spiraux.

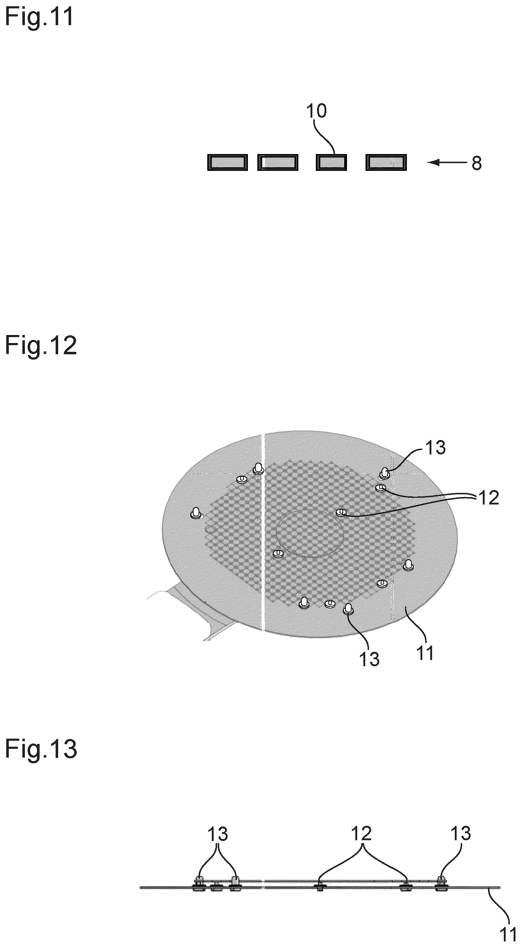

A encore une autre étape du procédé (figure 11), une couche d'oxyde de silicium (SiO₂) 10 est formée sur la plaquette 8 et ses composants horlogers, par exemple par oxydation thermique ou par dépôt chimique ou physique en phase vapeur (CVD, PVD). Cette couche d'oxyde de silicium 10 qui enrobe les composants horlogers renforce leur résistance mécanique. Dans le cas d'un spiral, la couche d'oxyde de silicium 10 a une épaisseur qui lui permet de compenser les variations en fonction de la température du module d'élasticité de l'âme en silicium ainsi que les variations en fonction de la température du moment d'inertie du balancier que le spiral est destiné à équiper, afin que la fréquence de l'oscillateur balancier-spiral soit insensible à la température, comme décrit dans les brevets EP 1422436 et EP 2215531.

A une étape finale, les composants horlogers sont détachés de la structure de base de la plaquette 8.

Selon l'invention, durant les étapes d'oxydation (figures 7 et 9 et, le cas échéant, figure 11), la plaquette 8 est supportée horizontalement par une plaque de support 11 telle qu'illustrée aux figures 12 et 13, pouvant être manipulée manuellement ou par un robot. Cette plaque de support 11 est dans un matériau compatible avec le traitement d'oxydation, par exemple le quartz, le silicium ou le carbure de silicium. Pour permettre une oxydation homogène de la plaquette 8, cette dernière est surélevée par rapport à la plaquette de support 11 par des entretoises 12 qui soutiennent la plaquette 8 dans des zones qui ne contiennent pas de composants (notamment entre les composants). La plaquette 8 est empêchée de bouger horizontalement par des éléments de retenue 13 coopérant avec le pourtour de la plaquette 8. Les entretoises 12 et les éléments de retenue 13 sont de forme générale cylindrique. Ils sont solidaires de la plaque de support 11, par exemple fixés à la plaque de support 11 par des liaisons de type baïonnette. Ils sont réalisés par exemple en quartz ou en carbure de silicium, et peuvent être dans le même matériau ou dans des matériaux différents. Dans un exemple de réalisation préféré, la plaque de support 11 est en silicium et les entretoises et éléments de retenue 12, 13 sont en quartz. Une telle plaque de support 11 avec ses entretoises 12 et éléments de retenue 13 peut aussi être utilisée pendant l'étape de la figure 11 lorsque celle-ci consiste en une opération de dépôt CVD ou PVD.

De préférence, durant le traitement d'oxydation de la figure 9, la plaquette 8 est placée sur la plaque de support 11 dans une position retournée par rapport au traitement d'oxydation de la figure 7. De même, durant le traitement d'oxydation ou de dépôt de la figure 11, la plaquette 8 est placée sur la plaque de support 11 dans une position retournée par rapport au traitement d'oxydation de la figure 9. Ceci permet d'éviter que des déformations permanentes se produisent dans les composants horlogers sous l'effet de la pesanteur et de la chaleur, ou d'au moins limiter ces déformations.

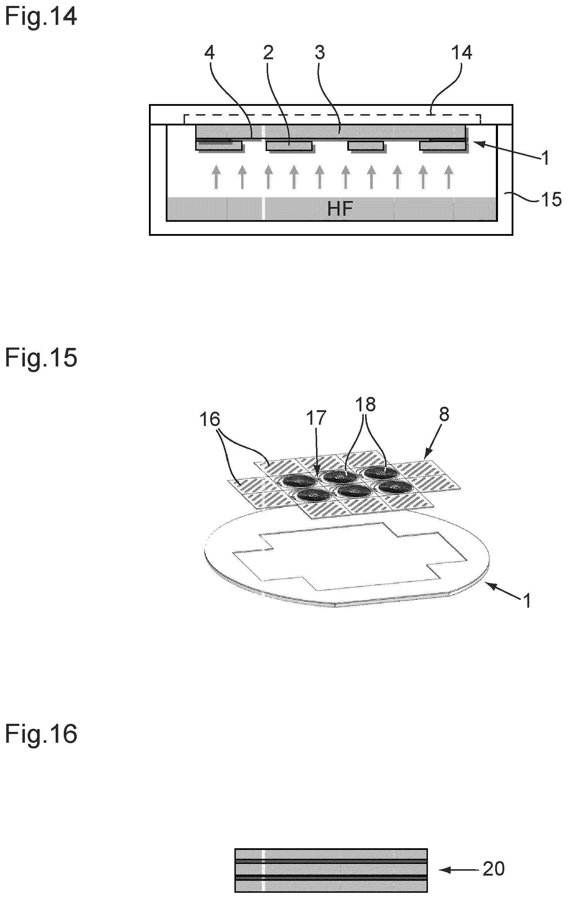

L'étape de libération de la plaquette 8 du substrat 1 (figure 6) peut être mise en œuvre par élimination de toute la couche inférieure de silicium 3 et de toute la couche intermédiaire d'oxyde de silicium 4 par gravure chimique ou gravure plasma. On peut aussi retirer la couche inférieure de silicium 3 et la couche intermédiaire d'oxyde de silicium 4 seulement au dos des composants ou des groupes de composants, la plaquette 8 gardant alors une partie de ces couches 3, 4. Toutefois, ces opérations sont longues et coûteuses. De préférence, la plaquette 8 est formée par une partie de la couche supérieure de silicium 2 et sa libération du substrat 1 est mise en œuvre de la manière exposée ci-dessous et illustrée aux figures 14 et 15.

On fixe le substrat 1 gravé tel que montré à la figure 5 contre un élément chauffant 14 dans une chambre fermée 15 (figure 14), la couche supérieure de silicium 2 étant orientée vers le bas, la couche inférieure de silicium 3, orientée donc vers le haut, étant contre l'élément chauffant 14. Le mode de fixation du substrat 1 contre l'élément chauffant 14 peut être électrostatique (par application d'un champ électrique) ou mécanique. Une solution d'acide fluorhydrique (HF) est ajoutée dans la chambre 15, hors de contact avec le substrat 1. Les vapeurs de l'acide fluorhydrique qui saturent alors l'intérieur de la chambre 15 gravent la couche intermédiaire d'oxyde de silicium 4, sans attaquer le silicium. L'élément chauffant 14, régulé en température, empêche la condensation de l'eau produite par la réaction entre l'acide fluorhydrique et l'oxyde de silicium, condensation qui provoquerait un collage entre la partie à libérer et le reste du substrat 1.

La partie à libérer, à savoir la plaquette 8, est définie préalablement par une saignée réalisée lors de la gravure de la couche supérieure de silicium 2 et qui forme le pourtour de la plaquette 8. Pendant cette même gravure de la couche supérieure de silicium 2, des ouvertures 16, par exemple en forme de hachures comme représenté à la figure 15, sont gravées dans la plaquette 8 autour d'une zone centrale 17 comprenant les composants. Ces ouvertures 16 permettent le passage de la vapeur d'acide fluorhydrique.

La figure 15 montre un exemple de plaquette 8 ayant une forme constituée de parties rectangulaires ou carrées. D'autres formes peuvent bien sûr être envisagées, par exemple la forme circulaire. A la figure 15 on peut voir les composants horlogers 18 portés par la plaquette 8, ici constitués de spiraux. Ces composants horlogers ont été représentés en nombre réduit par rapport à leur nombre réel, afin de faciliter la lecture du dessin.

Les composants horlogers fabriqués par le procédé décrit ci-dessus peuvent avoir des dimensions très précises et de bons états de surface qui amélioreront la précision de fonctionnement et le rendement des mécanismes qui les utiliseront.

Des modifications du procédé tel que décrit ci-dessus sont bien entendu possibles.

Par exemple, bien que les deux étapes d'oxydation-désoxydation (figures 7, 8 et figures 9, 10) pour respectivement améliorer l'état de surface des composants horlogers et ajuster leur raideur (dans le cas de spiraux) soient particulièrement avantageuses, on pourrait n'en prévoir qu'une, à la fois pour améliorer l'état de surface et ajuster la raideur, que précéderait une étape de détermination de la raideur.

On pourrait aussi partir d'un substrat double ou triple SOI, voire plus, c'est-à-dire d'un substrat comprenant plus de deux couches de silicium séparées par des couches intermédiaires d'oxyde de silicium, comme le substrat 20 montré à la figure 16, et graver les composants horlogers dans un groupe de couches supérieures qui serait ensuite libéré du substrat. Les composants horlogers auraient alors une structure composite comprenant une ou plusieurs couches intermédiaires d'oxyde de silicium.

Le masque de laque photosensible 5 qui sert à structurer la couche supérieure de silicium 2 (figure 3) pourrait être remplacé par un masque d'oxyde de silicium. On pourrait aussi associer un masque de laque photosensible et un masque d'oxyde de silicium pour réaliser par gravure dans la couche supérieure de silicium ou dans un groupe de couches supérieures des composants horlogers multiniveaux.

Dans d'autres variantes, on pourrait graver le substrat depuis ses deux faces.

La ou les couches d'oxydes de silicium servant à arrêter la gravure pourraient être renforcées par une ou des couches de type parylène.

Enfin, la présente invention n'exclut pas non plus l'utilisation d'une ou plusieurs couches métalliques pour arrêter la gravure.

## Revendications

1. Procédé de fabrication de composants horlogers comprenant les étapes suivantes :
a) se munir d'un substrat (1) comprenant une couche supérieure de silicium (2), une couche inférieure de silicium (3) et, entre les deux, une couche intermédiaire d'oxyde de silicium (4),
b) graver la couche supérieure de silicium (2) afin d'y former les composants horlogers,
c) libérer du substrat (1) une plaquette (8) formée par au moins tout ou partie de la couche supérieure de silicium (2) gravée, la plaquette (8) comprenant une structure de base et les composants horlogers attachés à la structure de base par des ponts de matière laissés lors de l'étape b),
d) oxyder thermiquement la plaquette (8) dans un four d'oxydation, puis désoxyder la plaquette (8),
e) former une couche d'oxyde de silicium (10) sur la plaquette (8) de sorte que cette couche d'oxyde de silicium (10) enrobe les composants horlogers, et
f) détacher les composants horlogers de la structure de base de la plaquette (8).

2. Procédé de fabrication de composants horlogers comprenant les étapes suivantes :
a) se munir d'un substrat (20) comprenant plus de deux couches de silicium séparées par des couches intermédiaires d'oxyde de silicium,
b) graver un groupe de couches supérieures du substrat (20) afin d'y former les composants horlogers, de sorte que les composants horlogers aient une structure composite comprenant une ou plusieurs couches intermédiaires d'oxyde de silicium,
c) libérer du substrat une plaquette formée par le groupe de couches supérieures gravé, la plaquette comprenant une structure de base et les composants horlogers attachés à la structure de base par des ponts de matière laissés lors de l'étape b),
d) oxyder thermiquement la plaquette dans un four d'oxydation, puis désoxyder la plaquette,
e) former une couche d'oxyde de silicium sur la plaquette de sorte que cette couche d'oxyde de silicium enrobe les composants horlogers, et
f) détacher les composants horlogers de la structure de base de la plaquette.

3. Procédé selon la revendication 1, dans lequel à l'étape b) la couche supérieure de silicium (2) est gravée par gravure ionique réactive profonde à travers un masque de laque photosensible (5) et/ou un masque d'oxyde de silicium.

4. Procédé selon la revendication 1 ou 3, dans lequel la plaquette (8) est formée par une partie de la couche supérieure de silicium (2) gravée.

5. Procédé selon la revendication 4, dans lequel une saignée est réalisée dans la couche supérieure de silicium (2) lors de l'étape b) pour former le pourtour de la plaquette (8) à libérer à l'étape c).

6. Procédé selon la revendication 5, dans lequel des ouvertures (16) sont gravées dans la couche supérieure de silicium (2) lors de l'étape b) de sorte que ces ouvertures (16) soient disposées, dans la plaquette (8) à libérer à l'étape c), autour d'une zone centrale (17) comprenant les composants horlogers, ces ouvertures (16) permettant le passage de vapeur d'acide fluorhydrique pour graver la couche intermédiaire d'oxyde de silicium (4) lors de l'étape c).

7. Procédé selon la revendication 6, dans lequel les ouvertures (16) sont en forme de hachures.

8. Procédé selon l'une des revendications 5 à 7, dans lequel à l'étape c) le substrat (1) comprenant la couche supérieure de silicium (2) gravée est fixé contre un élément chauffant (14) dans une chambre fermée (15), la couche supérieure de silicium (2) gravée étant orientée vers le bas, la couche inférieure de silicium (3) étant contre l'élément chauffant (14), et une solution d'acide fluorhydrique est ajoutée dans la chambre (15), hors de contact avec le substrat (1), de sorte que les vapeurs de l'acide fluorhydrique saturent l'intérieur de la chambre (15) et gravent la couche intermédiaire d'oxyde de silicium (4).

9. Procédé selon la revendication 8, dans lequel l'élément chauffant (14) est régulé en température pour empêcher la condensation de l'eau produite par la réaction entre l'acide fluorhydrique et l'oxyde de silicium.

10. Procédé selon l'une des revendications 1 à 9, comprenant en outre, seulement après l'étape d), et avant l'étape e), une étape de mesure de caractéristiques physiques des composants horlogers ou de certains d'entre eux.

11. Procédé selon l'une des revendications 1 à 9, dans lequel les composants horlogers sont des spiraux, le procédé comprenant en outre, seulement après l'étape d), et avant l'étape e), une étape de détermination de la raideur des spiraux.

12. Procédé selon la revendication 11, comprenant en outre, après l'étape de détermination de la raideur des spiraux et avant l'étape e), une étape consistant à oxyder thermiquement la plaquette (8) dans un four d'oxydation puis à désoxyder la plaquette (8) afin d'ajuster la raideur des spiraux.

13. Procédé selon la revendication 12, comprenant en outre, après l'étape de détermination de la raideur des spiraux et avant l'étape consistant à oxyder thermiquement la plaquette (8) dans un four d'oxydation puis à désoxyder la plaquette (8) afin d'ajuster la raideur des spiraux, une étape de calcul d'une épaisseur de matériau à retirer des spiraux pour obtenir une raideur souhaitée.

14. Procédé selon l'une des revendications 1 à 10, dans lequel les composants horlogers comprennent au moins l'un des types de composants suivants : spiraux, ancres, roues, aiguilles, bascules, leviers, ressorts, balanciers, ou des parties de tels composants.

15. Procédé selon l'une des revendications 1 à 10, dans lequel les composants horlogers comprennent au moins l'un des types de composants suivants : ancres, roues, aiguilles, bascules, leviers, balanciers, ou des parties de tels composants.

## Patentansprüche

1. Verfahren zur Herstellung von Uhrenkomponenten, das die folgenden Schritte umfasst:
a) Bereitstellen eines Substrats (1), das eine obere Siliziumschicht (2), eine untere Siliziumschicht (3) und zwischen den beiden eine Siliziumoxid-Zwischenschicht (4) umfasst,
b) Ätzen der oberen Siliziumschicht (2), um die Uhrenkomponenten darin zu bilden,
c) Befreien eines Plättchens (8), das aus mindestens der gesamten geätzten oberen Siliziumschicht (2) oder einem Teil davon gebildet ist, von dem Substrat (1), wobei das Plättchen (8) eine Basisstruktur und die Uhrenkomponenten umfasst, die über Materialbrücken, die beim Schritt b) belassen wurden, an der Basisstruktur angebracht sind,
d) thermisches Oxidieren des Plättchens (8) in einem Oxidationsofen, dann Desoxidieren des Plättchens (8),
e) Bilden einer Siliziumoxidschicht (10) auf dem Plättchen (8), derart dass diese Siliziumoxidschicht (10) die Uhrenkomponenten überzieht, und
f) Lösen der Uhrenkomponenten von der Basisstruktur des Plättchens (8).

2. Verfahren zur Herstellung von Uhrenkomponenten, das die folgenden Schritte umfasst:
a) Bereitstellen eines Substrats (20), das mehr als zwei Siliziumschichten umfasst, die durch Siliziumoxid-Zwischenschichten getrennt sind,
b) Ätzen einer Gruppe von oberen Schichten des Substrats (20), um darin die Uhrenkomponenten zu bilden, derart dass die Uhrenkomponenten eine Verbundstruktur aufweisen, die eine oder mehrere Siliziumoxid-Zwischenschichten umfasst,
c) Befreien eines Plättchens, das aus der geätzten Gruppe von oberen Schichten gebildet ist, von dem Substrat, wobei das Plättchen eine Basisstruktur und die Uhrenkomponenten umfasst, die über Materialbrücken, die beim Schritt b) belassen wurden, an der Basisstruktur angebracht sind;
d) thermisches Oxidieren des Plättchens in einem Oxidationsofen, dann Desoxidieren des Plättchens,
e) Bilden einer Siliziumoxidschicht auf dem Plättchen, derart dass diese Siliziumoxidschicht die Uhrenkomponenten überzieht, und
f) Lösen der Uhrenkomponenten von der Basisstruktur des Plättchens.

3. Verfahren nach Anspruch 1, wobei im Schritt b) die obere Siliziumschicht (2) durch reaktives Ionentiefenätzen durch eine Maske (5) aus lichtempfindlichem Lack und/oder eine Siliziumoxidmaske geätzt wird.

4. Verfahren nach Anspruch 1 oder 3, wobei das Plättchen (8) aus einem Teil der geätzten oberen Siliziumschicht (2) gebildet ist.

5. Verfahren nach Anspruch 4, wobei im Schritt b) in der oberen Siliziumschicht (2) eine Einkerbung ausgeführt wird, um den Umfang des im Schritt c) zu befreienden Plättchens (8) zu bilden.

6. Verfahren nach Anspruch 5, wobei beim Schritt b) Öffnungen (16) in die obere Siliziumschicht (2) geätzt werden, derart dass diese Öffnungen (16) in dem im Schritt c) zu befreienden Plättchen (8) um eine zentrale Zone (17) herum angeordnet sind, welche die Uhrenkomponenten umfasst, wobei diese Öffnungen (16) den Durchgang von Fluorwasserstoffsäuredampf zum Ätzen der Siliziumoxid-Zwischenschicht (4) im Schritt c) erlauben.

7. Verfahren nach Anspruch 6, wobei die Öffnungen (16) in der Form von Schraffurlinien vorliegen.

8. Verfahren nach einem der Ansprüche 5 bis 7, wobei im Schritt c) das Substrat (1), das die geätzte obere Siliziumschicht (2) umfasst, gegen ein Heizelement (14) in einer geschlossenen Kammer (15) befestigt wird, wobei die geätzte obere Siliziumschicht (2) nach unten gerichtet ist, die untere Siliziumschicht (3) gegen das Heizelement (14) anliegt und eine Fluorwasserstoffsäurelösung in der Kammer (15) außer Kontakt mit dem Substrat (1) beigegeben wird, derart dass die Fluorwasserstoffsäuredämpfe den Innenraum der Kammer (15) sättigen und die Siliziumoxid-Zwischenschicht (4) ätzen.

9. Verfahren nach Anspruch 8, wobei die Temperatur des Heizelements (14) geregelt wird, um die Kondensation des Wassers zu verhindern, das von der Reaktion zwischen der Fluorwasserstoffsäure und dem Siliziumoxid erzeugt wird.

10. Verfahren nach einem der Ansprüche 1 bis 9, das ferner erst nach dem Schritt d) und vor dem Schritt e) einen Schritt zum Messen physikalischer Eigenschaften der Uhrenkomponenten oder einiger davon umfasst.

11. Verfahren nach einem der Ansprüche 1 bis 9, wobei die Uhrenkomponenten Spiralfedern sind, wobei das Verfahren ferner erst nach dem Schritt d) und vor dem Schritt e) einen Schritt zur Bestimmung der Steifigkeit der Spiralfedern umfasst.

12. Verfahren nach Anspruch 11, das ferner nach dem Schritt zur Bestimmung der Steifigkeit der Spiralfedern und vor dem Schritt e) einen Schritt umfasst, der im thermischen Oxidieren des Plättchens (8) in einem Oxidationsofen und dann im Desoxidieren des Plättchens (8) besteht, um die Steifigkeit der Spiralfedern anzupassen.

13. Verfahren nach Anspruch 12, das ferner nach dem Schritt zur Bestimmung der Steifigkeit der Spiralfedern und vor dem Schritt, der im thermischen Oxidieren des Plättchens (8) in einem Oxidationsofen und dann im Desoxidieren des Plättchens (8) besteht, um die Steifigkeit der Spiralfedern anzupassen, einen Schritt zur Berechnung einer Dicke des Materials umfasst, das von den Spiralfedern zu entfernen ist, um eine gewünschte Steifigkeit zu erhalten.

14. Verfahren nach einem der Ansprüche 1 bis 10, wobei die Uhrenkomponenten mindestens einen der folgenden Typen von Komponenten umfassen: Spiralfedern, Anker, Räder, Zeiger, Wippen, Hebel, Federn, Unruhen oder Teile solcher Komponenten.

15. Verfahren nach einem der Ansprüche 1 bis 10, wobei die Uhrenkomponenten mindestens einen der folgenden Typen von Komponenten umfassen: Anker, Räder, Zeiger, Wippen, Hebel, Unruhen oder Teile solcher Komponenten.

## Claims

1. Method of manufacturing timepiece components comprising the following steps:
a) obtaining a substrate (1) comprising an upper silicon layer (2), a lower silicon layer (3) and, between the two, an intermediate silicon oxide layer (4),
b) etching the upper silicon layer (2) so as to form the timepiece components therein,
c) releasing from the substrate (1) a plate (8) formed by at least all or part of the etched upper silicon layer (2), the plate (8) comprising a base structure and the timepiece components attached to the base structure by bridges of material left during step b),
d) thermally oxidising the plate (8) in an oxidation furnace, then deoxidising the plate (8),
e) forming a silicon oxide layer (10) on the plate (8) so that this silicon oxide layer (10) coats the timepiece components, and
f) detaching the timepiece components from the base structure of the plate (8).

2. Method of manufacturing timepiece components comprising the following steps:
a) obtaining a substrate (20) comprising more than two layers of silicon separated by intermediate layers of silicon oxide,
b) etching a group of upper layers of the substrate (20) so as to form the timepiece components therein so that the timepiece components have a composite structure comprising one or more intermediate silicon oxide layers,
c) releasing from the substrate a plate formed by the etched group of upper layers, the plate comprising a base structure and the timepiece components attached to the base structure by bridges of material left during step b),
d) thermally oxidising the plate in an oxidation furnace, then deoxidising the plate,
e) forming a silicon oxide layer on the plate so that this silicon oxide layer coats the timepiece components, and
f) detaching the timepiece components from the base structure of the plate.

3. Method as claimed in claim 1, wherein, in step b), the upper silicon layer (2) is etched by deep reactive-ion etching through a mask of photosensitive lacquer (5) and/or a mask of silicon oxide.

4. Method as claimed in claim 1 or 3, wherein the plate (8) is formed by a part of the etched upper silicon layer (2).

5. Method as claimed in claim 4, wherein a groove is produced in the upper silicon layer (2) during step b) to form the periphery of the plate (8) to be released in step c).

6. Method as claimed in claim 5, wherein openings (16) are etched in the upper silicon layer (2) during step b) so that these openings (16) are disposed, in the plate (8) to be released in step c), about a central zone (17) comprising the timepiece components, these openings (16) allowing the passage of hydrofluoric acid vapour in order to etch the intermediate silicon oxide layer (4) during step c).

7. Method as claimed in claim 6, wherein the openings (16) are in the form of hatching.

8. Method as claimed in any one of claims 5 to 7, wherein, in step c), the substrate (1) comprising the etched upper silicon layer (2) is fixed against a heating element (14) in a closed chamber (15), the etched upper silicon layer (2) being orientated downwards, the lower silicon layer (3) being against the heating element (14), and a hydrofluoric acid solution is added into the chamber (15), out of contact with the substrate (1), so that the hydrofluoric acid vapours saturate the interior of the chamber (15) and etch the intermediate silicon oxide layer (4).

9. Method as claimed in claim 8, wherein the temperature of the heating element (14) is regulated in order to prevent the condensation of the water produced by the reaction between the hydrofluoric acid and the silicon oxide.

10. Method as claimed in any one of claims 1 à 9, further comprising, only after step d) and before step e), a step of measuring physical features of the timepiece components or of some of them.

11. Method as claimed in any one of claims 1 to 9, wherein the timepiece components are hairsprings, the method further comprising, only after step d) and before step e), a step of determining the stiffness of the hairsprings.

12. Method as claimed in claim 11, further comprising, after the step of determining the stiffness of the hairsprings and before step e), a step consisting of thermally oxidising the plate (8) in an oxidation furnace and then deoxidising the plate (8) in order to adjust the stiffness of the hairsprings.

13. Method as claimed in claim 12, further comprising, after the step of determining the stiffness of the hairsprings and before the step consisting of thermally oxidising the plate (8) in an oxidation furnace then deoxidising the plate (8) in order to adjust the stiffness of the hairsprings, a step of calculating a thickness of material to remove from the hairsprings in order to obtain a desired stiffness.

14. Method as claimed in any one of claims 1 to 10, wherein the timepiece components comprise at least one of the following types of components: hairsprings, pallets, wheels, hands, rockers, levers, springs, balances, or parts of such components.

15. Method as claimed in any one of claims 1 to 10, wherein the timepiece components comprise at least one of the following types of components: pallets, wheels, hands, rockers, levers, balances, or parts of such components.
